Europäisches Patentamt

European Patent Office

Office européen des brevets

(19)

(11) Numéro de publication: **0 046 421**
**B1**

(12) **FASCICULE DE BREVET EUROPEEN**

(45) Date de publication du fascicule du brevet: **19.09.84**

(21) Numéro de dépôt: **81401223.3**

(22) Date de dépôt: **29.07.81**

(51) Int. Cl.³: **G 08 C 23/00,** H 04 B 9/00, H 03 F 3/08

(54) Récepteur pour système de transmission de signaux par rayonnement électromagnétique, notamment infrarouge.

(30) Priorité: **20.08.80 FR 8018184**

(43) Date de publication de la demande:
**24.02.82 Bulletin 82/08**

(45) Mention de la délivrance du brevet:
**19.09.84 Bulletin 84/38**

(84) Etats contractants désignés:
**DE GB IT**

(56) Documents cités:
**DE-A-2 263 440**
**FR-A-2 370 268**

**ELECTRONICS LETTERS, 27 septembre 1979,**
**vol. 15, no. 20 Londres, GB OGAWA et al.:**
**"GaAs F.E.T. transimpedance front-end design**
**for a wideband optical receiver" pages 650-652**
**FUNKSCHAU, vol. 44, no. 10, mai 1972 Münich,**
**DE MÜLLER-VOGT: "Fernsteuern mit**
**Wechsellicht", pages 353-355**

(73) Titulaire: **Deutsche Thomson-Brandt GmbH**
**Hermann-Schwer-Strasse 3**
**D-7730 Villingen-Schwenningen (DE)**

(72) Inventeur: **Geiger, Erich**
**THOMSON-CSF SCPI 173, bld Haussmann**
**F-75360 Paris Cedex 08 (FR)**
Inventeur: **Tan, Wah Keng**
**THOMSON-CSF SCPI 173, bld Haussmann**
**F-75360 Paris Cedex 08 (FR)**

(56) Documents cités:
**ELECTRONIQUE ET MICROELECTRONIQUE**
**INDUSTRIELLES, no. 216, 1er mars 1976 Paris,**
**FR ZULAUF: "Les transmissions sans fil à**
**courte distance se mettent aux infrarouges",**
**pages 37-43**
**"Electronic devices and circuits", 1967, p.560-**
**563**

Courier Press, Leamington Spa, England.

## Description

La présente invention concerne un récepteur pour système de transmission de signaux, notamment de signaux de télécommande, par un rayonnement électromagnétique, notamment du rayonnement infrarouge, du type dans lequel des impulsions codées d'amplitude constante ou une onde porteuse de fréquence ultrasonore modulée par de telles impulsions, par exemple, alimente un émetteur de ce rayonnement qui peut être constitué par une diode électroluminescente ou émettrice de lumière (à arseniure de gallium, par exemple). Lorsque la diode électroluminescente, émettrice de ce rayonnement, est alimentée par des impulsions d'amplitude et de durée constantes, la fréquence porteuse sera alors considérée comme l'inverse du double de la durée des impulsions.

Dans les systèmes de télécommande par rayonnement infrarouge, connus de ce genre, décrits, par exemple, dans un article d'ELSHUBER de la revue allemande ELEKTRONIK, volume 19, n° 11, du mois d'octobre de 1970 ou dans la publication DE—A—22 63 440 (voir préambule de la revendication 1), les récepteur comporte généralement un détecteur de ce rayonnement comprenant un diviseur de tension de type résistif composé d'une résistance fixe et d'un élément dont la résistance (ou le courant) varie en fonction de l'intensité du rayonnement qu'il reçoit, tel qu'une photodiode ou un phototransistor au silicium, connectés en série entre les pôles d'une source de basse tension continue. La jonction de cette résistance et de l'élément sensible au rayonnement est couplée à l'entrée d'un préamplificateur accordé à la fréquence de l'onde porteuse comprenant en cascade plusiers étages d'amplification équipés de transistors bipolaires à jonctions dont quelques uns au moins sont à couplage capacitif et munis de circuits de polarisation automatique variable à l'aide de montages composés d'une résistance et d'une capacité connectées en parallèle dans le circuit émetteur des transistors. Ce préamplificateur alimente un étage dé détecteur d'amplitude ou de mise en forme des impulsions qui fournit des impulsions de polarité positive dont la composante à la fréquence de l'onde porteuse est éliminé ainsi qu'en grande partie le bruit affectant celle-ci, de manière à fournir à l'étage de sortie équipé d'un transistor de commutation rapide, par exemple, un niveau logique haut pendant la durée des impulsions modulant la porteuse et un niveau logique bas, en l'absence de celles-ci. L'étage de mise en forme comporte à cet effet un filtre passe-bas ou intégrateur dont la fréquence de coupure haute est inférieure à la fréquence de l'onde porteuse. Un autre exemple d'un système de télécommande par rayonnement infrarouge connu, utilisant la modulation du rayonnement par des impulsions sans porteuse supplémentaire, c'est-à-dire en attaquant la diode émettrice de lumière par des impulsions codées au moyen de la variation des intervalles de temps entre deux impulsions successives ou par la position relative de celles-ci (appelée "pulse position modulation" ou "PPM" dans la littérature anglo-américaine), a été décrit dans un article de KARNATZKI aux pages 55 à 59 du n° 435 de la revue française "TOUTE L'ELECTRONIQUE" des mois d'août et de septembre de l'année 1978. Le signal de télécommande est composé ici d'une impulsion préliminaire activant le récepteur de télécommande suivie d'une impulsion de démarrage ou "start" qui précède un mot d'adresse de 4 bits suivi d'un mot d'instructions de 6 bits, les digits binaires "0" et "1" sont différentiés par les intervalles de 100 ou de 300 microsecondes entre deux impulsions successives de 10 microsecondes de durée. Le mot d'instructions est suivi à son tour d'une impulsion d'arrêt ou "stop". Ceci est obtenu à l'aide d'un émetteur comprenant un clavier à touches monocontact dont les sorties alimentent un circuit intégré de type SAA 1050 d'ITT Intermetall comprenant un oscillateur RC comme horloge. Du côté réception, un détecteur d'infrarouge alimente un préamplificateur à commande automatique de gain qui alimente à son tour un circuit intégré du type SAA 1051 comprenant un oscillateur piloté par un quartz (à la fréquence de la sous-porteuse de chrominance PAL), un convertisseur de code, un circuit de contrôle et des convertisseurs N/A.

La partie amont ("front end" en anglais) d'un récepteur optique à large bande, recevant des signaux fournis par une photodiode et décrit dans l'article d'OGAWA et al. aux pages 650 à 652 du N° 20, Vol. 15 de la revue britannique "ELECTRONICS LETTERS" datée du 27 septembre 1979, comprend en cascade un étage d'entré équipé d'un transistor à effet de champ en arséniure de gallium, monté en source commune, dont le drain est relié à un premier transistor bipolaire de type PNP, monté en base commune. Le collecteur du premier transistor bipolaire est relié à la base d'un second transistor bipolaire de type complémentaire (NPN) à celui du premier, monté en collecteur commun. Ce circuit utilise donc un transistor à effet de champ hyperfréquence à jonction et deux transistors bipolaires hyperfréquence complémentaires montés respectivement en base et en collecteur communs, en vue d'obtenir un préamplificateur à large bande passante et à faible bruit en utilisant une contre-réaction par résistance réunissant l'émetteur du second transistor bipolaire à la grille du transistor à effet de champ.

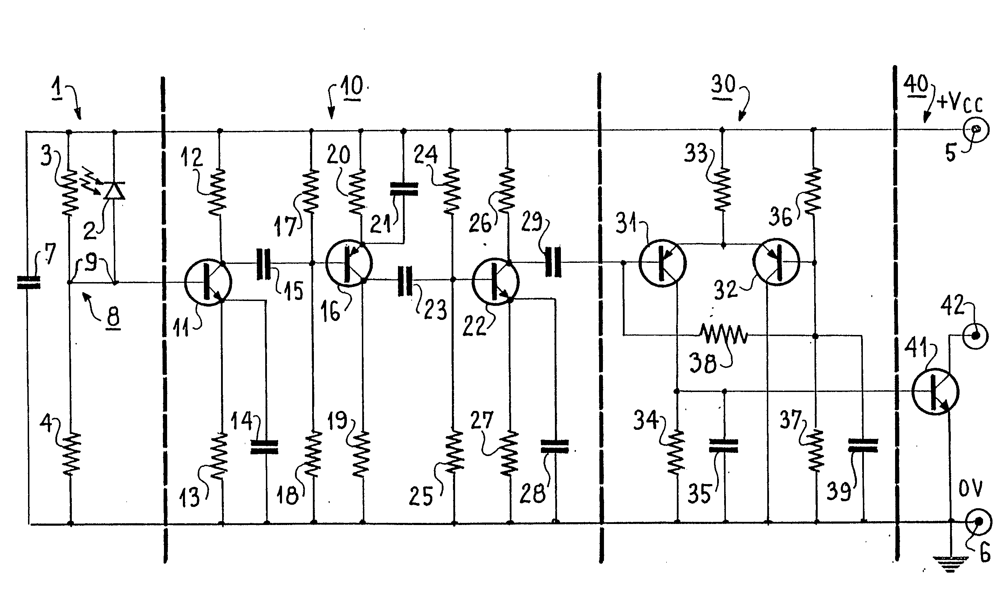

Dans la publication FR—A—2 370 268 (ou US—A—4 110 608), on a décrit un dipôle photodétecteur à amplificateur incorporé dont l'un des modes de réalisation (Fig. 5) comporte un circuit composé de deux transistors complémentaires dont le premier, monté en émetteur commun est du type NPN et dont le second, monté en collecteur commun, est dy type PNP, le collecteur du premier étant relié à la base du second transistor dont l'émetteur et le collecteur constituent les bornes respectives du dipôle. La photodiode qui est polarisée à l'envers au moyen d'un diviseur résistif connecté entre ces bornes, est montée en anti-parallèle (tête-bêche) avec la jonction base-émetteur du premier transistor de sorte qu'un accroissement instantané de son rayonnement incident provoque une réduction du courant collecteur du premier transistor qui alimente la base du second de façon à provoquer une réduction correspondante du courant émetteur de ce dernier. Les bornes de ce dipôle, sont respectivement reliées à celle d'un montage composé d'une résistance de charge et d'une source de tension continue d'alimentation connectées en série, de sorte que les variations du courant émetteur du second transistor provoquent des variations correspondantes de la chute de tension aux bornes de cette résistance de charge.

Les principales caractéristiques d'un récepteur de télécommande par rayonnement infrarouge sont sa sensibilité qui détermine la distance maximale possible entre l'émetteur et le récepteur, sa protection contre la saturation lorsque l'émetteur est situé au voisinage du récepteur et l'immunité face aux perturbations qui peuvent provenir de sources de lumière ou de rayonnement parasite ou d'émetteurs de télécommande voisins. La sensibilité élevée et la protection contre la saturation étant des critères contradictoires, le problème a été résolu dans la technique antérieure en utilisant dans le récepteur des circuits de commande automatique de gain avec des amplificateurs à gain variable en fonction d'une grandeur électrique telle qu'une tension prélevée à la sortie de la chaîne d'amplification après redressement de crête et filtrage passe-bas ou intégration. Cette intégration impose un retard à la réponse du circuit de commande automatique de fain qui est loin d'être instantanée. L'immunité aux signaux parasites y est assurée par l'utilisation d'une porteuse modulée par des impulsions codées d'une manière prédéterminée et en équipant les étages d'entrée du récepteur de filtres électriques passifs ou actifs dont la caractéristique passe-bande est centrée sur la fréquence de la porteuse.

La présente invention permet de remédier aux inconvénients des récepteurs de télécommande de la technique antérieure, notamment en ce qui concerne le temps de réponse de la commande automatique de gain, tout en utilisant des éléments de couplage et de polarisation automatique de type déjà existant pour obtenir le filtrage de l'onde porteuse et la protection contre la saturation.

L'invention a pour objet un récepteur pour système de transmission de signaux impulsionnels, notamment de télécommande, par rayonnement électromagnétique, notamment infrarouge, du type dans lequel le rayonnement lui-même ou une porteuse est modulé par des impulsions d'amplitude constante, codées de manière prédéterminée et comprenant en cascade: un détecteur de ce rayonnement du type comprenant un diviseur de tension résistif dont l'une des branches comprend un élément détecteur dont la résistance et/ou le courant varie en fonction de l'intensité du rayonnement qu'il reçoit, un préamplificateur de type passe-bande dont la bande passante comprend la fréquence de la porteuse ou celle égale à l'inverse du double de la durée des impulsions, lorsqu'elle est constante, et comprenant plusieurs étages en cascade, équipés chacun d'un transistor monté en émetteur commun, dont le circuit émetteur comprend un montage de polarisation automatique composé d'une résistance et d'un condensateur connectés en parallèle et dont le circuit de base comprend un montage de polarisation du type diviseur de tension résistif, un étage de mise en forme des impulsions reçues et un étage de sortie destiné à alimenter un décodeur des impulsions modulant le rayonnement ou la porteuse.

Suivant l'invention, les valeurs respectives des résistances et des condensateurs équipant respectivement les circuits émetteurs des transistors en aval de l'étage d'entrée du préamplificateur, sont choisies de manière à former des circuits intégrateurs d'impulsions dont les constantes de temps à la décharge sont d'un ordre de grandeur comparable à la durée minimale de l'intervalle entre deux impulsions successives d'un train d'impulsions constituant le signal modulant le rayonnement ou la porteuse, pour que la polarisation automatique additionnelle de l'émetteur par rapport à la base, obtenue par la recharge rapide du condensateur par chaque impulsion reçue, soit fonction de l'amplitude de cette impulsion et conserve dans cet intervalle une valeur suffisante pour éliminer ou affaiblir des impulsions parasites qui se produiraient au cours de la transmission de ce train, à la place d'impulsions d'écart de temps minimal.

Suivant une autre caractéristique de l'invention, les valeurs respectives des résistances et des condensateurs de ces montages de polarisation automatique dans les circuits émetteurs des transistors sont choisies, par ailleurs, de manière à former des circuits de contre-réaction de courant sélective, de type passe-bas pour chaque étage, dont la fréquence de coupure haute, calculée en considérant la somme de la combinaison parallèle des résistances réunies à la base et de la résistance base-émetteur interne, divisée par le gain de courant direct en émetteur commun, en parallèle avec ce montage, est choisie inférieure à la fréquence de la porteuse ou à celle égale à l'inverse du double de la durée constante des impulsions codées.

Dans l'un des modes de réalisation du récepteur selon l'invention, qui est du type dans lequel le premier transistor équipant l'étage d'entrée du préamplificateur a son collecteur réuni par une résistance collecteur à l'un des pôles d'une source de tension d'alimentation et son émetteur réuni par une résistance émetteur shuntée par un condensateur à l'autre pôle de la source, le rapport des résistances collecteur et émetteur est choisi inférieur à l'unité et la constante de temps du montage parallèle du circuit émetteur est choisie de telle sorte que la contre-réaction en courant qu'elle engendre provoque une atténuation notable aux fréquences très inférieures à celle de la porteuse ou à celle égale à l'inverse du double de la durée des impulsions, lorsqu'elle est constante.

Dans un autre mode de réalisation du récepteur selon l'invention, qui est du type dans lequel, en outre, les étages successifs du préamplificateur sont couplés à l'aide de condensateurs de couplage, de sorte que ceux-ci réunissent respectivement la base du transistor de l'étage concerné au collecteur du transistor de l'étage précédent, en l'absence d'impulsions de rayonnement reçues, les transistors sont respectivement polarisés sur leurs bases à l'aide des montages diviseurs résistifs et sur leurs émetteurs à l'aide des résistances des montages de polarisation automatique, qui du fait du choix des valeurs respectives de celles-ci, les maintiennent légèrement au-dessus de leur tension de coupure et, par conséquent, le type du transistor de chaque étage est choisi de telle sorte que les impulsions correspondant à un accroissement du rayonnement incident, fournies à sa base par la sortie de l'étage précédent provoquent un accroissement de son courant collecteur, ce qui pour des montages à émetteur commun en cascade signifie d'équiper le préamplificateur alternativement de transistors complémentaires.

Dans un des modes de réalisation du récepteur, les capacités des condensateurs de couplage sont respectivement choisies de manière à former avec la somme des composantes résistives des impédances de sortie de l'étage précédent et d'entrée de l'étage concerné, des filtres passe-haut dont la fréquence de coupure basse est inférieure à la fréquence de la porteuse ou à celle égale à l'inverse du double de la durée des impulsions, lorsqu'elle est constante.

Dans un autre mode de réalisation, l'étage de mise en forme des impulsions de sortie du récepteur suivant l'invention alimenté par le préamplificateur, comporte un amplificateur différentiel à deux transistors couplés par leurs émetteurs, de type complémentaire à celui du transistor équipant le dernier étage de celui-ci, dont le premier a sa base couplée au collecteur de ce dernier au moyen d'un condensateur de couplage et dont le second est polarisé pour conduire en l'absence de signal impulsionnel, à l'aide d'un diviseur de tension résistif dont le point milieu est relié à sa base.

La base de ce premier transistor de l'amplificateur différentiel est, de préférence, polarisée au-delà de sa tension de coupure de manière à engendrer une tension de seuil que le signal doit dépasser afin de la rendre conducteur, en vue d'éliminer le bruit l'affectant par ébasage.

Cette polarisation de la base de ce premier transistor est obtenue, de préférence, en la réunissant à celle du second transistor de l'amplificateur différentiel par l'intermédiaire d'une résistance de valeur très élevée (supérieure à 1 mégohm, par exemple).

Le circuit collecteur de celui des transistors de l'étage de mise en forme, qui alimente l'étage de sortie du récepteur comporte avantageusement un circuit intégrateur ou filtre passe-bas composé d'une résistance et d'un condensateur montés en parallèle, dont la fréquence de coupure haute peut être choisie de manière à bloquer la transmission de la fréquence porteuse, lorsqu'une impulsion modulante comporte plusieurs périodes de celle-ci. Lorsque l'on utilise un code du type PPM où des impulsions brèves sont transmis sans porteuse, la fréquence de coupure haute doit être choisie notablement supérieure à la fréquence de coupure basse du préamplificateur, pour permettre la transmission des fronts de montée et de descente relativement raides de ces impulsions.

L'invention sera mieux comprise et d'autres de ses caractéristiques et avantages ressortiront de la description qui suit et du dessin annexé, s'y rapportant, dont la figure unique représente le schéma de principe du mode de réalisation préféré du récepteur de télécommande (ou de transmission de signaux impulsionnels) par rayonnement électromagnétique, notamment par rayonnement infrarouge.

Sur la figure, on a désigné par le repère 1 le montage détecteur du rayonnement infrarouge comprenant une photodiode 2 à silicium (par exemple, du type BPW 34 de la société allemande dite "SIEMENS AKTIENGESELL-SCHAFT", qui est adaptée à recevoir le rayonnement émis par des diodes électroluminescentes en arseniure de gallium du type LD 241 ou CQY 99 de cette même société, par exemple), une première résistance 3 de forte valeur (d'une centaine de kiloohms ou plus, par exemple), montée en parallèle avec la photodiode 2 et une seconde résistance 4 montée en série avec le montage parallèle de la photodiode 2 et de la première résistance 3. Le point commun de la cathode de la photodiode 2 et de cette première résistance 3 est reliée à la borne d'alimentation positive 5 du circuit, tandis que l'une des bornes de la seconde résistance 4 dont l'autre borne est reliée au point commun 9 de l'anode de la photodiode 2 et de la première résistance 3, est reliée à la borne d'alimentation négative 6. Les bornes d'alimentation 5 et 6 sont réunies ensemble au moyen d'un premier condensateur de découplage 7.

Il est bien entendu, possible de remplacer la photodiode 2 par un phototransistor comme dans la publication DE—A—22 63 400 précitée.

La photodiode 2 forme donc, avec la première résistance en parallèle, une première branche d'un premier diviseur résistif *8* dont la seconde branche est constituée par la seconde résistance 4 (de valeur de quelques centaines de kiloohms, par exemple).

Le courant inverse parcourant la photodiode 2 varie en fonction de l'intensité du rayonnement irradiant sa surface photosensible (avec une sensibilité supérieure à 50 nA/lx), de sorte que sa résistance équivalente varie également.

La sortie du montage détecteur 1, constituée par la jonction 9 des deux branches du premier diviseur résistif 8, est directement reliée à l'entrée d'un préamplificateur 10, qui et constitué par la base d'un premier transistor 11 de façon à former un circuit de polarisation de cette base. On obtient ainsi que la variation du courant inverse de la photodiode 2 alimentant la base du premier transistor 11 monté en émetteur commun, entraîne celle du courant collecteur de ce dernier.

Le collecteur de ce premier transistor 11 qui est choisi du type NPN afin qu'une augmentation de l'intensité du rayonnement reçu par la photodiode 2 provoque une augmentation de son courant collecteur, est réuni par l'intermédiaire d'une troisième résistance 12 à la borne d'alimentation positive 5. L'émetteur du premier transistor 11 est réuni au moyen d'un premier montage contre-réaction sélective composé d'une quatrième résistance 13 et d'un second condensateur 14 ("by-pass") connectés en parallèle, à la borne d'alimentation négative 6. Les valeurs respectives de la résistance 13 (270 kiloohms) et de la capacité du condensateur 14 (100 picofarads) ont été choisies principalement de manière à produire, conjointement avec le choix du rapport entre les valeurs des résistances collecteur 12 et émetteur 13 de cet étage d'entrée qui doit être inférieur à un (c'est-à-dire, de préférence, aux environs de 0,4), une forte atténuation des signaux parasites provenant des sources de lumière électrique ambiante dont la fréquence est égale ou inférieure à 100 hertz, afin d'éviter la saturation de cet étage par ces signaux parasites.

Le collecteur du premier transistor 11 du type NPN est couplé au moyen d'un troisième condensateur de couplage 15 à la base d'un second transistor 16 monté également en émetteur commun, qui est polarisée à l'aide d'un second diviseur de tension résistif composé d'un cinquième 17 et d'une sixième 18 résistance, connectées en série entre les bornes d'alimentation 5 et 6 avec leur jonction reliée à la base.

Le second transistor 16 est choisi, suivant l'invention, du type PNP, c'est-à-dire complémentaire à celui 11 de l'étage précédent, pour qu'une variation de sens déterminé du courant collecteur de ce dernier engendre une variation dans le même sens de celui du second transistor 16. Le collecteur du second transistor 16 est réuni par l'intermédiaire d'une septième résistance 19 à la borne d'alimentation négative 6, tandis que son émetteur est réuni au moyen d'un second montage de contre-réaction sélective et de polarisation automatique, composé d'une huitième résistance 20 et d'un quatrième condensateur 21 montés en parallèle, à la borne d'alimentation positive 5.

Le collecteur du second transistor 16 est, par ailleurs, couplé à la base d'un troisième transistor 22 également monté en émetteur commun, au moyen d'un cinquième condensateur 23 de couplage. Cette base est réunie au moyen d'une neuvième résistance 24 à la borne d'alimentation positive 5 et au moyen d'un dixième résistance 25 à la borne d'alimentation négative 6, de manière à former un troisième diviseur de polarisation résistif 24—25.

Le collecteur du troisième transistor 22 qui est choisi suivant l'invention du type NPN, complémentaire à celui de l'étage précédent, est réuni à la borne d'alimentation positive 5 au moyen d'une onzième résistance 26. Son émetteur est réuni à la borne d'alimentation négative à travers un troisième montage de contre-réaction sélective et de polarisation automatique, composé d'une douzième résistance 27 et d'un sixième condensateur 28 connectés en parallèle.

Par ailleurs, le collecteur du troisième transistor 22 est couplé à l'entrée de l'étage de mise en forme 30 au moyen d'un septième condensateur de couplage 29.

De ce qui précède, il ressort clairement que, conformément à l'invention, les transistors 11, 16 et 22 qui équipent les étages en cascade du préamplificateur 10 sont alternativement de type complémentaire de sorte qu'une variation de l'intensité du rayonnement incident du photodétecteur 2 dans un sens déterminé (positif) provoque une variation de même sens des courants collecteurs des étages successifs, les valeurs des résistances 17—18, et 24—25 équipant les deux diviseurs résistifs de polarisation de leurs bases sont choisies, de préférence, de manière à les polariser, en l'absence de signal reçu, à proximité de leur tension base-émetteur de blocage ou coupure (dite "cut-off" en anglais), de sorte que leurs courants collecteurs soient sensiblement nuls ou proches de zéro (très faibles).

Ceci présente l'avantage, d'une part, de réduire la consommation à l'état de veille au minimum et, d'autre part, d'assurer une grande dynamique d'entrée en permettant la réception et l'exploitation des impulsions codés ou de l'onde porteuse modulée par des impulsions dont l'amplitude crête sature tous les étages du préamplificateur, car l'effet de cette saturation n'est que l'écrêtage des excursions positives de l'onde porteuse et l'allongement de la durée de ces excursions, par chaque étage saturé, par le temps de stockage des porteurs minoritaires dans la base ("$t_s$"). Un tel agencement du récepteur est, de ce fait, particulièrement bien adapté à un système fonctionnant dans le mode PPM susmentionné ("modulation par la variation de l'écart de temps entre de brèves impulsions successives, notamment pour la transmission de signaux numériques") dont l'avantage est le rapport cyclique réduit et dans lequel une onde porteuse ayant une fréquence de l'ordre de plusieurs dizaines de kHz (entre 40 et 120 kHz, par exemple) est modulée par des impulsions dont la durée est égale à l'inverse du double de la fréquence porteuse, qui est de l'ordre de quelques ou quelques dizaines de microsecondes, par exemple, avec un écart minimal d'une dizaine de millisecondes environ. Pour une fréquence porteuse de 50 kHz (c'est-à-dire une période de 20 microsecondes) et une modulation par des impulsions de durée de 10 microsecondes, chacune de celles-ci ne comporterait qu'une seule excursion positive de même durée qui serait prolongée par chaque étage saturé de quelques centaines de nanosecondes, par exemple.

La protection du préamplificateur 10 contre la saturation est rendue plus efficace par les montages de polarisation automatique 13—14, 20—21 et 27—28, connus en soi, constituant les circuits émetteurs respectifs des transistors 11, 16 et 22. A chaque excursion positive de l'intensité du rayonnement incident sur la surface photosensible de la photodiode 2, correspond une impulsion des courants collecteur et émetteur, dont la seconde charge rapidement le condensateur "by-pass" 21 ou 28 et provoque aux bornes de la résistance émetteur 20 ou 27 à laquelle il est connecté en parallèle, une chute de tension. Cette chute de tension et, par conséquent, la tension aux bornes du condensateur 21 ou 28 est proportionnelle, à la fin de l'impulsion, à l'amplitude crête de celle-ci, Après l'annulation ou la réduction brutale du courant, le condensateur 21 ou 28 se décharge exponentiellement notamment à travers la résistance émetteur 20 ou 27 associée, avec une constante de temps à la décharge égale au produit de leurs valeurs respectives. Si cette constante de temps est choisie d'un ordre de grandeur comparable à la durée de l'intervalle de temps minimal entre deux impulsions consécutives d'un train d'impulsions constituant le signal modulant la porteuse, l'émetteur du transistor est alors polarisé à l'arrivée d'une impulsion parasite à la place d'une impulsion du train correspondant à cet écart minimal, par une tension émetteur $v_E$ sensiblement continue qui varie en fonction de l'amplitude de l'impulsion précédente et qui est soustraite de la tension de polarisation continue de la base $V_B$ fournie par le diviseur résistif 17—18 et 24—25 de sorte que la tension base-émetteur $v_{BE}$, égale à $V_B$—$v_E$, varie de manière inverse à la variation de l'amplitude du signal. Il est bien connu que lorsque la tension base-émetteur $v_{BE}$ du transistor est proche mais supérieure à la tension de coupure (blocage), son gain de courant direct $\beta_F$ (ou $h_{FE}$) en émetteur commun varie comme une fonction non-linéaire de cette tension. Il se produit, par conséquent, un effet de variation automatique de gain de chaque transistor en fonction inverse de l'amplitude crête de son signal d'entrée et l'impulsion parasite d'amplitude plus faible sera éliminée. En outre, lorsque l'amplitude crête du signal d'entrée croît au-delà d'une certaine valeur prédéterminée, celle de la chute de tension aux bornes de la résistance émetteur 20 ou 27 devient suffisante pour que la tension de polarisation de l'émetteur $v_E$ aux bornes du condensateur 21 ou 28, polarise le transistor 16 ou 22 au delà de sa tension de coupure, après la réception de la première impulsion d'un train de celles-ci et pendant au moins une partie la durée de ce train. De cette manière, uniquement les parties supérieures des impulsions suivantes provoquent des augmentations de ses courants collecteur et émetteur, permettant ainsi d'éliminer totalement les impulsions parasites d'amplitude plus faible.

Par ailleurs, même lorsque l'amplitude crête du signal d'entrée est telle que la tension base-émetteur atteint sa valeur de saturation ($v_{BEsat} = 0,7$ volts environ pour des transistors NPN au silicium), la jonction base-émetteur devient alors une diode à polarisation directe et entraîne le calage (dit "clamping" en anglais) des crêtes des impulsions à cette valeur, grâce au couplage capacitif entre les étages en cascade. La base du train d'impulsions pendant les intervalles entre deux impulsions successives, qui est généralement entachée de bruit, est alors située bien au-delà de la valeur de coupure de la tension base-émetteur et le bruit est pratiquement entièrement éliminé des bases et des crêtes des impulsions de sortie de l'étage, prélevées sur le collecteur.

La caractéristique passe-bande de la fonction de transfert du préamplificateur 10 est obtenue, d'une part, par le choix des capacités des condensateurs de couplage 15, 23 et, éventuellement 29 et de celles des condensateurs 14, 21 et 28 qui sont montés en parallèle avec les résistances émetteur 13, 20 et 27 pour obtenir la fonction de transfert passe-haut, c'est-à-dire la fréquence de coupure basse (—3dB), désirée qui est choisie, par exemple, au moins de quelques kilohertz inférieure à la fréquence de l'onde porteuse et, d'autre part, par le choix du type de transistor 11, 16 et 22, et de la valeur de la résistance chargeant le circuit collecteur de celui-ci qui est composé de la résistance collecteur de l'étage considéré et des résistances d'entrée de l'étage suivant en parallèle pour déterminer la fréquence de coupure haute. Le choix du type de transistor détermine, en effet, la fréquence de transition $f_T$, la fréquence de coupure $\beta$, $f_\beta$ qui dépendent des paramètres intrinsèques de celui-ci, tels que les capacités incrémentales de ses jonctions base-émetteur ($C_\pi$) et base-collecteur ($C_\mu$), et les différentes résistances de ces jonctions ($r_\pi$, $r_\mu$) et de la base ($r_x$). La fréquence de coupure haute ainsi obtenue est choisie, par exemple de quelques ou de quelques dizaines de kilohertz supérieure à la fréquence de l'onde porteuse qui constitue la fréquence du gain maximal (centrale) de la caractéristique amplitude-fréquence du préamplificateur. Lors de l'utilisation de code PPM précité, cette fréquence centrale peut être choisie égale, par exemple, à l'inverse du double de la durée des impulsions, qui est constante.

Le calcul des fréquences de coupure précités d'un préamplificateur du type décrit, à couplage RC et à contre-réaction sélective en courant à chaque étage à l'aide de circuits émetteur formés par des montages RC parallèles est décrit, par exemple, dans les ouvrages de SEARLE et al. intitulé "Elementary Circuit Properties of Transistors" et de THORNTON et al. intitulé "Multistage Transistor Circuits", constituant respectivement les volumes 3 et 5 de la série "Semiconductor Electronics Education Committee Books" publiée par John Wiley & Sons, Inc. en 1964 et 1965 ou encore notamment aux pages 579 à 614 de l'ouvrage de HOLT intitulé "Electronic Circuits", publié par le même éditeur en 1978.

De ce qui précède, il résulte que les circuits émetteurs de chacun des transistors 16 et 29 constitués par des montages RC parallèles doivent remplir deux fonctions dont l'une est la mémorisation de l'amplitude des impulsions de courant émetteur afin de conserver une polarisation de l'émetteur suffisante pour éliminer les parasites et le bruit, ce qui demande une constante de temps à la décharge relativement élevée dans laquelle n'interviennent que les valeurs de $R_e$ et de $C_e$ et dont l'autre est de contribuer à la détermination de la fréquence de coupure basse par contre-réaction de type passe-bas, où interviennent en parallèle avec la résistance émetteur $R_e$, la résistance d'entrée de l'étage concerné et de sortie de l'étage précédent divisés par le gain de courant de l'étage. Le calcul doit donc être effectué de manière itérative pour trouver les valeurs qui conviennent en fonction du type de transistor et des valeurs des résistances collecteur et de base choisis en fonction des autres critères précités.

L'étage de mise en forme 30 des impulsions est équipé d'un amplificateur différentiel du type à deux transistors 31, 32 couplés par leurs émetteurs, polarisés au repos dans le mode différentiel ou déséquilibré, pour qu'en l'absence de signal reçu, l'un des transistors soit conducteur et l'autre bloqué, afin d'obtenir un effet de seuil permettant d'éliminer le bruit.

Les deux transistors 31, 32 de l'étage de mise en forme 30 qui constituent respectivement le quatrième 31 et le cinquième 32 transistors du récepteur, sont choisis, pour les raisons indiquées ci-dessus, de type complémentaire à celui 22 de l'étage de sortie du préamplificateur 10 qui alimente son entrée, c'est-à-dire ici du type PNP. Leurs émetteurs sont reliés ensemble et réunis, par l'intermédiaire d'une treizième résistance 33, dite résistance émetteur commune (de l'ordre du kiloohm, par exemple) à la borne d'alimentation positive 5. Le collecteur du quatrième transistor 31 est réuni à la borne d'alimentation négative 6 au moyen d'un circuit intégrateur ou filtre passe-bas composé d'une quatorzième résistance 34 et d'un huitième condensateur 35 montés en parallèle. Le collecteur du cinquième transistor 32 est directement relié à la borne d'alimentation négative 6.

La base du cinquième transistor 32 est polarisée au moyen d'un quatrième diviseur résistif composé d'une quinzième 36 et d'une seizième 37 résistance, montées en série entre les bornes d'alimentation positive 5 et négative 6. Le point commun de ces deux résistances 36 et 37 est relié à la base du cinquième transistor 36 afin de lui fournir, par exemple, une tension légèrement supérieure à la moitié de la tension d'alimentation $V_{cc}$ appliquée entre les bornes 5, 6, et réuni au moyen d'une dix-septième résistance 38 de très forte valeur (de l'ordre du mégohm ou plus) à la base du quatrième transistor 31 de manière à lui fournir une tension émetteur-base notablement supérieure à celle du cinquième transistor 32 qui est polarisé pour conduire un courant émetteur provoquant aux bornes de la troisième résistance 33 une chute de tension déterminée par le diviseur de polarisation 36—37. Il suffit alors d'un très faible courant de fuite provenant de la base du quatrième transistor 31 pour provoquer aux bornes de la dix-septième résistance 38 une chute de tension suffisante pour qu'il soit polarisé au-delà de sa tension de coupure. On obtient ainsi une tension de seuil de la conduction du quatrième transistor 31 qui est sensiblement égale à cette chute de tension $V_{38}$ correspondant à la différence entre les potentiels de base respectifs des deux transistors 31, 32 de l'amplificateur différentiel (qui est choisie de 0,1 volts, par exemple). La valeur de cette dix-septième résistance 38 est alors avantageusement choisie en fonction du niveau du bruit en sortie du préamplificateur 10.

Lorsque le signal d'entrée du préamplificateur 10 présent à la jonction 9 et engendré par le rayonnement pulsé reçu par la photodiode 2 est faible, c'est-à-dire insuffisant pour provoquer la saturation de l'un quelconque des transistors 11, 16 et 22, ceux-ci fonctionnent pour la totalité de l'amplitude de l'impulsion dans leurs régions actives respectives qui peuvent être considérés comme quasi-linéaires au moins en ce qui concerne la partie du signal impulsionnel dépassant le bruit.

Dans ce cas, le bruit affectant la base du signal impulsionnel est éliminé par le seuil de conduction du quatrième transistor 31, tandis que le bruit superposé à la crête de ce signal est atténué à l'aide du filtre passe-bas ou intégrateur 34—35 situé dans le circuit collecteur de celui-ci. Lorsque la fréquence de l'onde porteuse et la durée des impulsions qui la modulent sont choisies, l'une par rapport à l'autre, de sorte que la durée minimale comporte deux ou plusieurs périodes de porteuse, il est avantageux de choisir la constante de temps de cet intégrateur 34—35 supérieure à cette période (de préférence, au moins égale au triple d'une demi-période, c'est-à-dire de l'intervalle entre deux alternances positives successives, de la porteuse) pour qu'elle soit éliminée de manière à restituer les impulsions modulantes sous la forme d'un signal à deux niveaux logiques distincts (binaire). Par contre, lorsque la durée des impulsions est comprise entre une période ou une demi-période de la porteuse de sorte que chaque impulsion ne comporte qu'une alternance, la constante de temps 34—35 est choisie, de préférence, de telle sorte que la fréquence de coupure haute à laquelle elle correspond soit au moins égale au double de la fréquence de l'onde porteuse.

Par ailleurs, le point commun de la quinzième 36, de la seizième 37 (qui sont de l'ordre d'une centaine de kiloohms), de la dix-septième 38 résistance et de la base du cinquième transistor 32, est réuni à la masse au moyen d'un neuvième condensateur 39 de découplage empêchant la transmission du signal impulsionnel à la base de ce dernier qui doit rester polarisée à une tension sensiblement constante.

Lorsque l'amplitude crête du signal d'entrée augmente de telle sorte que la chute de tension provoquée par le courant émetteur de l'un des transistors 22 ou 16, aux bornes de sa résistance émetteur 27 ou 20 et chargeant les condensateurs 28 ou 21 qui leur sont respectivement reliés en parallèle, dépasse la différence entre la tension de polarisation au repos et la tension de coupure au moins d'une valeur correspondant au niveau crête du bruit, il se produit, en l'absence d'impulsions, un ébasage de ce dernier qui est alors situé au-delà de la tension de coupure, car le condensateur 28 ou 21 se charge alors à la valeur crête de cette chute de tension et il conserve cette tension en fonction de la constante de temps du montage RC formant le circuit émetteur. Un choix judicieux de cette constante de temps permet, par exemple, de protéger le récepteur contre des signaux parasites provenant d'un autre émetteur, pendant la transmission des signaux émis par l'émetteur qui lui est associé.

Lorsque l'amplitude crête de signaux s'accroît encore, il se produit un phénomène d'écrêtage par saturation et de calage ("clamping") des crêtes d'abord dans le transistor de sortie 22 du préamplificateur 10 et ensuite dans celui 16 de l'étage précédent, sans aucune perte de signal utile.

On remarquera ici que l'invention n'est pas limitée à un préamplificateur de trois étages mais peut en comporter moins ou plus utilisant le même principe de l'alternance des types de transistors, complémentaires, montés en émetteur commun, couplés par condensateur et munis dans leurs circuits émetteur de montages RC parallèles. En outre, lorsqu'il s'avère qu'il est avantageux de disposer à la sortie de l'étage de mise en forme 30 de signaux complémentaires à ceux présents au collecteur du quatrième transistor 31, on peut charger le collecteur du cinquième transistor 32 au moyen d'un circuit analogue à l'intégrateur 34—35.

Le collecteur du quatrième transistor 31 qui constitue la sortie de l'étage de mise en forme 30, est directement relié à la base d'un sixième transistor 41 de type NPN, c'est-à-dire complémentaire à celui des transistors 31, 32 équipant l'amplificateur différentiel 30. L'émetteur du sixième transistor 41 est relié à la borne d'alimentation négative 6. Le sixième transistor 41 équipant l'étage de sortie 40 du récepteur, qui est destiné, par exemple, à alimenter un décodeur en forme de circuit intégré monolithique et adapté à coopérer avec un codeur situé dans l'émetteur, connus en soi (non représentés), est choisi de type à commutation de puissance, par exemple.

Le collecteur du sixième transistor 41 est relié à la sortie 42 du récepteur de façon à constituer un étage à collecteur ouvert qui présente l'avantage que ce collecteur peut être alimenté d'une autre source de tension positive que celle ($+ V_{cc}$) alimentant le récepteur de la figure. Cette source de tension peut alors, de ce fait, être dimensionnée pour une puissance fournie relativement faible. Ceci est indispensable pour les récepteurs de télécommande devant commander la mise en route d'équipements électriques ou électroniques tels qu'un récepteur de télévision, des équipements périphériques ou une chaîne de haute-fidélité, par exemple, du fait que les récepteurs de télécommande doivent être alimentés en permanence (état de veille).

Il est, en outre, évident que le rayonnement électromagnétique peut être autre que le rayonnement infrarouge émis par des diodes électroluminescentes de GaAs, tel que par exemple, une lumière monochromatique produit par des diodes GaP, GaAlAs ou GaAsP (rouge ou vert), à condition d'utiliser une photodiode 2 ou un phototransistor adapté à recevoir ce rayonnement (voir DE—A—22 63 440 précité).

Dans un exemple de réalisation du récepteur de télécommande par infrarouge suivant l'invention, les valeurs de composants utilisés ont été les suivantes:

— $R_3$, $R_{12}$, $R_{19}$, $R_{26}$, $R_{37}$ et $R_{38}$ de 100 kiloohms;
 $R_4$ de 220 kiloohms; $R_{13}$ et $R_{25}$ de 270 kiloohms;
 $R_{17}$ de 390 kiloohms; $R_{20}$ et $R_{27}$ de 470 kiloohms;
 $R_{18}$ et $R_{24}$ de 1 mégohm; $R_{33}$ de 1 kiloohm;
 $R_{34}$ de 8 kiloohms et $R_{38}$ de 1,5 mégohms; et
— $C_{14}$, $C_{15}$ et $C_{23}$ de 100 picofarads; $C_{35}$ de 1 nanofarad;
 $C_7$ et $C_{39}$ de 10 nanofarads; $C_{29}$ de 22 nanofarads;
 $C_{21}$ et $C_{28}$ de 47 nanofarads.

## Revendications

1. Récepteur pour système de transmission de signaux impulsionnels, notamment de télécommande, par rayonnement électromagnétique, notamment infrarouge, du type dans lequel le rayonnement lui-même ou une porteuse est modulée par des impulsions d'amplitude constante, codées de manière prédéterminée, le récepteur comprenant en cascade: un étage détecteur (1) de ce rayonnement du type comprenant un diviseur de tension résistif (2, 3, 4) dont l'une des branches comprend un élément détecteur (2) dont la résistance et/ou le courant varie en fonction de l'intensité du rayonnement qu'il reçoit, un préamplificateur (10) de type passe-bande dont la bande passante comprend la fréquence de la porteuse ou celle égale à l'inverse du double de la durée des impulsions, lorsqu'elle est constante, et comprenant plusieurs étages en cascade, équipés chacun d'un transistor (11, 16, 22) monté en émetteur commun, dont le circuit émetteur comprend un montage de polarisation automatique composé d'une résistance (13, 20, 27) et d'un condensateur (14, 21, 28) connectés en parallèle et dont le circuit de base comprend un montage de polarisation du type diviseur de tension résistif (2-3-4, 17-18, 24-25), un étage de mise en forme (30) des impulsions reçues et un étage de sortie (40) destiné à alimenter un décodeur par des impulsions modulant le rayonnement ou la porteuse, caractérisé en ce que les valeurs respectives des résistances (20, 27) et des condensateurs (21, 28) équipant respectivement les circuits émetteurs des transistors (16, 22) en aval de l'étage d'entrée (11) du préamplificateur (10), sont choisies de manière à former des circuits intégrateurs d'impulsions dont les constantes de temps à la décharge sont d'un ordre de grandeur comparable à la durée minimale de l'intervalle entre deux impulsions successives d'un train d'impulsions constituant le signal modulant le rayonnement ou la porteuse, pour la polarisation automatique additionnelle de l'émetteur par rapport à la base, obtenue par la recharge rapide du condensateur par chaque impulsion reçue, soit fonction de l'amplitude de cette impulsion et conserve dans cet intervalle une valeur suffisante pour éliminer ou affaiblir des impulsions parasites qui se produiraient au cours de la transmission de ce train, à la place d'impulsions d'écart de temps minimal.

2. Récepteur suivant la revendication 1, caractérisé en ce que les valeurs respectives des résistances (20, 27) et des condensateurs (21, 28) de ces montes de polarisation automatique dans les circuits émetteurs des transistors (16, 22) sont choisies, par ailleurs, de manière à former des circuits de contre-réaction de courant sélective, de type passe-bas pour chaque étage, dont la fréquence de coupure haute, calculée en considérant la comme de la combinaison parallèle des résistances réunies à la base et de la résistance base-émetteur interne, divisée par le gain de courant direct en émetteur commun, en parallèle avec ce montage, est choisie inférieure à la fréquence de la porteuse ou à celle égale à l'inverse du double de la durée constante des impulsions codées.

3. Récepteur suivant l'une quelconque des revendications précédentes, du type dans lequel le premier transistor (11) équipant l'étage d'entrée du préamplificateur (10) a son collecteur réuni par une résistance collecteur (12) à l'un des pôles d'une source de tension d'alimentation et son émetteur réuni par une résistance émetteur (13) shuntée par un condensateur (14) à l'autre pôle (6) de la source, caractérisé en ce que le rapport des résistances collecteur (12) et émetteur (13) est inférieur à l'unité et en ce que la constante de temps du montage parallèle du circuit émetteur est choisie de telle sorte que la contre-réaction en courant qu'elle engendre provoque une atténuation notable aux fréquences très inférieures à celle de la porteuse ou à celle égale à l'inverse du double de la durée des impulsions, lorsqu'elle est constante.

4. Récepteur suivant l'une quelconque des revendications précédentes, du type dans lequel, en outre, les étages successifs du préamplificateur (10) sont couplés à l'aide de condensateurs de couplage (15, 23, 29), de sorte que ceux-ci réunissent respectivement la base du transistor (16 ou 22) de l'étage concerné au collecteur du transistor (11 ou 16) de l'étage précédent, caractérisé en ce que, en l'absence d'impulsions de rayonnement reçues, les transistors (11, 16, 22) respectivement polarisés sur leurs bases à l'aide des montages diviseurs résistifs (2-3-4, 17-18, 24-25) et sur leurs émetteurs à l'aide des résistances (13, 20, 27) des montages de polarisation automatique (13-14, 20-21, 27-28), qui du fait du choix des valeurs respectives de celles-ci (13, 20, 27), les maintiennent légèrement au-dessus de leur tension de coupure et en ce que le type du transistor (11, 16, 22) de chaque étage est choisi de telle sorte que les impulsions correspondant à un accroissement du rayonnement incident, fournies à sa base par la sortie de l'étage précédent provoquent un accroissement de son courant collecteur, ce qui pour des montages à émetteur commun en cascade signifie d'équiper le préamplificateur (10) alternativement de transistors complémentaries.

5. Récepteur suivant la revendication 4, caractérisé en ce que les capacités des condensateurs de couplage (15, 23, 29) sont respectivement choisies de manière à former avec la somme des composantes résistives respectives des impédances de sortie de l'étage précédent et d'entrée de l'étage concerné, des filtres passe-haut dont la fréquence de coupure basse est inférieure à la fréquence de la porteuse ou à celle égale à l'inverse du double de la durée des impulsions, lorsqu'elle est constante.

6. Récepteur suivant l'une quelconque des revendications précédentes, caractérisé en ce que l'étage de mise en forme (30) alimenté par le préamplificateur (10), comporte un amplificateur différentiel à deux transistors (31, 32) couplés par leurs émetteurs, de type complémentaire à celui du transistor (22) équipant le dernier étage de celui-ci, dont le premier (31) a sa base couplée au collecteur de ce dernier (22) au moyen d'un condensateur (29) et dont le second (32) est polarisé pour conduire en l'absence de signal impulsionnel, à l'aide d'un diviseur de tension résistif (36—37) dont le point commun est relié à sa base.

7. Récepteur suivant la revendication 6, caractérisé en ce que la base du premier transistor (31) de l'étage de mise en forme (30) est réunie à celle du second (32) ay moyen d'une résistance de forte valeur (38), aux bornes de laquelle le courant de base résiduel de premier transistor (31) provoque une chute de tension suffisante pour qu'il soit polarisé au-delà de sa coupure.

8. Récepteur suivant l'une quelconque des revendications 6 et 7, caractérisé en ce que celui (31) des transistors (31, 32) de l'amplificateur différentiel qui alimente l'étage de sortie (40), comporte dans son circuit collecteur un circuit intégrateur ou filtre passe-bas composé d'une résistance (34) et d'un condensateur (35) montés en parallèle et dont la fréquence de coupure haute est choisie de manière à réduire notablement le bruit affectant le signal impulsionnel, afin de fournir à l'étage de sortie (40) des signaux à deux niveaux logiques correspondant sensiblement aux impulsions modulant la porteuse ou le rayonnement.

9. Récepteur suivant l'une quelconque des revendications 6 à 8, caractérisé en ce que l'étage de sortie (40) comporte un transistor (41) bipolaire à jonction monté en émetteur commun et à collecteur ouvert.

10. Récepteur suivant la revendication 9, caractérisé en ce que la base du transistor (41) équipant l'étage de sortie (40) est directement reliee au collecteur de l'un des transistors (31, 32) équipant l'amplificateur différentiel.

11. Récepteur suivant la revendication 10, caractérisé en ce que le transistor (41) équipant l'étage de sortie (40) est de type complémentaire à ceux (31, 32) équipant l'amplificateur différentiel.

12. Récepteur suivant l'une quelconque des revendications 9 à 11, caractérisé en ce que la base du transistor (41) équipant l'étage de sortie (40), de type NPN, qui constitue un interrupteur électronique, est reliée au collecteur du premier transistor (31) de l'amplificateur différentiel qui fournit un état logique bas en l'absence d'impulsions et un état logique haut, lorsqu'elles sont présentes.

13. Application d'un récepteur de télécommande suivant l'une quelconque des revendications précédentes, à un système de télécommande par rayonnement électromagnétique, notamment infrarouge, comprenant un émetteur de télécommande séparé dans lequel des impulsions codées d'amplitude constante, modulant éventuellement une onde porteuse, servent à transmettre une pluralité de signaux de télécommande en alimentant au moins une diode électroluminescente, génératrice de ce rayonnement.

**Patentansprüche**

1. Empfänger für ein System zur Übertragung von Impulssignalen, insbesondere zur Fernsteuerung über elektromagnetische Strahlung, insbesondere Infrarotstrahlung, derjenigen Art, bei welcher die Strahlung selbst oder eine Trägerschwingung durch Impulse konstanter Amplitude moduliert wird, die in vorbestimmter Weise codiert sind, wobei der Empfänger in Kaskadenschaltung enthält: Eine Detektorstufe (1) zur Erfassung dieser Strahlung und mit einem resistiven Spannungsteiler (2, 3, 4), dessen einer Zweig ein Detektorelement (2) umfaßt, dessen Widerstand und/oder Strom in Abhängigkeit von der Intensität der durch ihn empfangenen Strahlung variiert, einen Vorverstärker (10) vom Bandpaß-Typ, dessen Durchlaßband die Frequenz des Trägers oder die Frequenz enthält, die gleich dem Kehrwert der doppelten Dauer der Impulse ist, wenn diese konstant ist, und welcher mehrere in Kaskade geschaltete Stufen umfaßt, die jeweils mit einem in Emitterschaltung geschalteten Transistor (11, 16, 22) ausgestattet sind, deren Emitterkreis eine Schaltungsanordnung zur automatischen Polarisierung umfaßt, welche einen Widerstand (13, 20, 27) und einen Kondensator (14, 21, 28) enthält, die parallel geschaltet sind, während der Basiskreis eine Polarisierungs-Schaltungsanordnung vom Typ eines resistiven Spannungsteilers (2-3-4, 17-18, 24-25) enthält, eine Stufe (30), welche die empfangenen Impulse in Form bringt, und eine Ausgangsstufe (40) umfaßt, die dazu bestimmt ist, einen Decoder mit Impulsen zu speisen, welche die Strahlung oder den Träger modulieren, dadurch gekennzeichnet, daß die jeweiligen Werte der Widerstände (20, 27) und der Kondensatoren (21, 28), welche jeweils die Emitterkreise der Transistoren (16, 22) hinter der Eingangsstufe (11) des Vorverstärkers (10) ausrüsten, so gewählt sind, daß sie Impulsintegrationsschaltungen bilden, deren Zeitkonstanten bei der Entladung von einer Größenordnung sind, die vergleichbar mit der minimalen Dauer des Intervalls zwischen zwei aufeinanderfolgenden Impulsen einer Impulsfolge ist, die das die Strahlung oder den Träger modulierende Signal bildet, damit die automatische zusätzliche Polarisierung des Emitters in Bezug auf die Basis, die bei dem schnellen Wiederaufladen des Kondensators durch jeden empfangenen Impuls erhalten wird, von der Amplitude dieses Impulses abhängt und innerhalb dieses Intervalls einen ausreichenden Wert beibehält, um Störimpulse zu eliminieren oder abzuschwächen, die im Verlauf der Übertragung dieser Impulsfolge an Stelle von dem minimalen Zeitabstand entsprechenden Impulsen auftreten könnten.

2. Empfänger nach Anspruch 1, dadurch gekennzeichnet, daß die jeweiligen Werte der Widerstände (20, 27) und Kondensatoren (21, 28) dieser Schaltungsanordnungen zur automatischen Polarisierung in den Emitterkreisen der Transistoren (16, 22) ferner so gewählt sind, daß selektive Stromgegenkopplungsschaltungen vom Tiefpaßtyp für jede Stufe gebildet werden, deren obere Grenzfrequenz, die unter Berücksichtigung der Summe aus der Parallelkombination der mit der Basis verbundenen Widerstände und dem internen Basis-Emitter-Widerstand, dividiert durch die direkte Stromverstärkung in zu dieser Schaltungsanordnung paralleler Emitterschaltung, berechnet wurde, kleiner als die Frequenz des Trägers oder diejenige Frequenz gewählt ist, die gleich dem Kehrwert der doppelten konstanten Dauer der codierten Impulse ist.

3. Empfänger nach einem der vorstehenden Ansprüche, derjenigen Art, bei welcher der erste Transistor (11) der Eingangsstufe des Vorverstärkers (10) an seinem Kollektor über einen Kollektorwiderstand (12) mit einem der Pole einer Versorgungsspannung verbunden ist und an seinem Emitter über einen Emitterwiderstand (13), der durch einen Kondensator (14) überbrückt ist, mit dem anderen Pol (6) der Quelle verbunden ist, dadurch gekennzeichnet, daß das Verhältnis von Kollektorwiderstand (12) zu Emitterwiderstand (13) kleiner als eine ist und daß die Zeitkonstante der zu dem Emitterkreis parallelen Schaltungsanordnung so gewählt ist, daß die durch sie verursachte Stromgegenkopplung eine beträchtliche Dämpfung der Frequenzen hervorruft, die sehr viel kleiner als die Frequenz des Trägers oder die Frequenz ist, die gleich dem Kehrwert der doppelten Dauer der Impulse ist, wenn diese konstant ist.

4. Empfänger nach einem der vorstehenden Ansprüche, von derjenigen Art, bei welcher ferner die aufeinander folgenden Stufen des Verstärkers (10) über Koppelkondensatoren (15, 23, 29) gekoppelt sind, so daß diese jeweils die Basis des Transistors (16 oder 22) der betreffenden Stufe mit dem Kollektor des Transistors (11 oder 16) der vorausgehenden Stufe verbinden, dadurch gekennzeichnet, daß beim Ausbleiben von empfangenen Strahlungsimpulsen die Transistoren (11, 16, 22) jeweils an ihren Basen mittels resistiven Spannungsteilern (2-3-4, 17-18, 24-25) und an ihren Emittern mittels der Widerstände (13, 20, 27) der Schaltungsanordnungen zur automatischen Polarisierung (13-14, 20-21, 27-28) polarisiert werden, welche aufgrund der jeweiligen Werte derselben (13, 20, 27) diese leicht oberhalb ihrer Grenzfrequenz halten, und daß der Transistortyp (11, 16, 22) jeder Stufe derart gewählt ist, daß die einer Zunahme der ankommenden Strahlung entsprechenden Impulse, welche durch den Ausgang der vorausgehenden Stufe an seine Basis angelegt werden, eine Zunahme seines Kollektorstromes hervorrufen, was für in Kaskade angeordnete Emitterschaltungen bedeutet, daß der Vorverstärker (10) mit einander abwechselnden komplementären Transistoren ausgerüstet ist.

5. Empfänger nach Anspruch 4, dadurch gekennzeichnet, daß die Kapazitäten der Kopplungskondensatoren (15, 23, 29) jeweils so gewählt sind, daß mit der Summe der jeweiligen resistiven Komponenten der Ausgangsimpedanzen der vorausgehenden Stufe und des Einganges der betreffenden Stufe Hochpaßfilter gebildet werden, deren untere Grenzfrequenz kleiner ist als die Frequenz des Trägers oder die Frequenz, die gleich dem Kehrwert der doppelten Dauer der Impulse ist, wenn diese konstant ist.

6. Empfänger nach einem der vorstehenden Ansprüche, dadurch gekennzeichnet, daß die Formgebungsstufe (30), die durch den Vorverstärker (10) gespeist wird, einen Differenzverstärker enthält, der zwei Transistoren (31, 32) aufweist, welche über ihre Emitter gekoppelt und komplementär zu dem Typ des Transistors (22) sind, welcher die letzte Stufe derselben ausstattet, wovon der erste (31) an seiner Basis mit dem Kollektor des letzteren (22) über einen Kondensator (29) gekoppelt ist und der zweite (32) mittels eines resistiven Spannungsteilers (36—37), dessen gemeinsamer Punkt mit seiner Basis verbunden ist, so polarisiert ist, daß er bei ausbleibendem Impulssignal leitet.

7. Empfänger nach Anspruch 6, dadurch gekennzeichnet, daß die Basis des ersten Transistors (31) der Formgebungsschaltung (30) mit der des zweiten (32) über einen Widerstand (38) verbunden ist, der einen hohen Wert besitzt und an dessen Anschlüssen der Basisreststrom des ersten Transistors (31) einen Spannungsabfall verursacht, der ausreicht, um ihn jenseits seiner Sperrung zu polarisieren.

8. Empfänger nach Anspruch 6 oder 7, dadurch gekennzeichnet, daß derjenige (31) der Transistoren (31, 32) des Differenzverstärkers, welcher die Ausgangsstufe (40) ansteuert, in seinem Kollektorkreis ein Integrierglied oder ein Tiefpaßfilter umfaßt, das aus einem Widerstand (34) und einem Kondensator (35) gebildet ist, die parallel geschaltet sind und deren obere Grenzfrequenz derart gewählt ist, daß das Rauschen beträchtlich gedämpft wird, welches das Impulssignal begleitet, um der Ausgangsstufe (40) Signale mit zwei Logikpegeln zuzuführen, die im wesentlichen den Impulsen entsprechen, welche den Träger oder die Strahlung modulieren.

9. Empfänger nach einem der Ansprüche 6 bis 8, dadurch gekennzeichnet, daß die Ausgangsstufe (40) einen bipolaren Transistor (41) mit Halbleiterübergang umfaßt, der in Emitterschaltung und mit offenem Kollektor angeordnet ist.

10. Enpfänger nach Anspruch 9, dadurch gekennzeichnet, daß die Basis des Transistors (41), mit dem die Ausgangsstufe (40) ausgestattet ist, direkt mit dem Kollektor eines der Transistoren (31, 32) verbunden ist, mit denen der Differenzverstärker ausgestattet ist.

11. Empfänger nach Anspruch 10, dadurch gekennzeichnet, daß der Transistor (41), mit dem die Ausgangsstufe (40) ausgestattet ist, komplementär zu denen (31, 32) ist, welche den Differenzverstärker ausstatten.

12. Empfänger nach einem der Ansprüche 9 bis 11, dadurch gekennzeichnet, daß die Basis des NPN-Transistors (41), mit dem die Ausgangsstufe (40) ausgestattet ist und der einen elektronischen Unterbrecher bildet, mit dem Kollektor des ersten Transistors (31) des Differenzverstärkers verbunden ist, der einen niedrigen Logikpegel liefert, wenn die Impulse ausbleiben, und einen hohen Logikpegel abgibt, wenn diese vorhanden sind.

13. Anwendung eines Fernsteuerungsempfängers nach einem der vorstehenden Ansprüche auf ein mit elektromagnetischer Strahlung arbeitendes Fernsteuersystem, das insbesondere im Infrarotbereich arbeitet, mit einem getrennten Fernsteuersender, in welchem codierte Impulse konstanter Amplitude gegebenenfalls eine Trägerschwingung modulieren und dazu dienen, eine Mehrzahl von Fernsteuersignalen zu übertragen, indem sie wenigstens eine diese Strahlung erzeugende Elektrolumineszenzdiode beaufschlagen.

**Claims**

1. Receiver in a system for the transmission of pulse signals, in particular of remote control signals, by electromagnetic radiation, in particular infrared radiation, of the type in which the radiation itself or a carrier is modulated by pulses of constant amplitude coded in predetermined manner, the receiver comprising in cascade: a detector stage (1) for detecting said radiation of the type comprising a resistive voltage divider (2, 3, 4), one of the branches of which comprises a detector element (2) whose resistance and/or current varies in dependence upon the intensity of the radiation which it receives, a preamplifier (10) of the band-pass type whose pass band includes the frequency of the carrier or the frequency equal to the reciprocal of twice the duration of the pulses when the latter is constant, and comprising a plurality of stages in cascade each equipped with a transistor (11, 16, 22) in common-emitter connection whose emitter circuit comprises a circuit arrangement for automatic biasing made up of a resistor (13, 20, 27) and a capacitor (14, 21, 28) connected in parallel and whose base circuit comprises a biasing circuit of the type of a resistive voltage divider (2-3-4, 17-18, 24-25), a stage (30) for shaping the received pulses and an output stage (40) adapted to feed a decoder with pulses modulating the radiation or the carrier, characterized in that the respective values of the resistors (20, 27) and the capacitors (21, 28) respectively equipping the emitter circuits of the transistors (16, 22) downstream of the input stage (11) of the preamplifier (10) are chosen so as to form pulse integrating circuits whose discharge time constants are of an order of magnitude comparable to the minimum duration of the interval between two successive pulses of a pulse train constituting the signal modulating the radiation or the carrier in order that the automatic additional biasing of the emitter with respect to the base obtained by the rapid recharging of the capacitor by each pulse received depends on the amplitude of said pulse and retains within said interval a value sufficient to eliminate or weaken parasitic pulses which would be produced in the course of the transmission of this train in place of minimum time spacing pulses.

2. Receiver according to claim 1, characterized in that the respective values of the resistors (20, 27) and capacitors (21, 28) of said automatic biasing circuit in the emitter circuits of the transistors (16, 22) are furthermore chosen so as to form selective negative current feedback circuits of low-pass type for each stage whose upper cut-off frequency calculated taking account of the sum of the parallel combination of the resistors connected to the base and the internal base-emitter resistance divided by the direct current gain in common emitter connection parallel to said circuit is chosen to be less than the frequency of the carrier or the frequency equal to the reciprocal of twice the constant duration of the coded pulses.

3. Receiver according to any one of the preceding claims, of the type in which the first transistor (11) of the input stage of the preamplifier (10) has its collector connected by a collector resistor (12) to one of the poles of a supply voltage source and its emitter connected by an emitter resistor (13) shunted by a capacitor (14) to the other pole (6) of the source, characterized in that the ratio of the collector resistor (12) and the emitter resistor (13) is less than one and in that the time constant of the circuit parallel to the emitter circuit is chosen such that the negative current feedback which it generates causes a considerable attenuation of the frequencies very much lower than that of the carrier or that equal to the reciprocal of twice the duration of the pulses when it is constant.

4. Receiver according to any one of the preceding claims of the type in which furthermore the successive stages of the preamplifier (10) are coupled with the aid of coupling capacitors (15, 23, 29) in such a manner that the latter respectively connect the base of the transistor (16 or 22) of the stage concerned to the collector of the transistor (11 or 16) of the preceding stage, characterized in that in the absence of received radiation pulses the transistors (11, 16, 22) respectively biased at their bases with the aid of resistive voltage dividers (2-3-4, 17-18, 24-25) and at their emitters with the aid of the resistors (13, 20, 27) of the automatic biasing circuits (13-14, 20-21, 27-28) which due to the choice of the respective values of the latter (13, 20, 27) maintain them slightly above their cut-off value, and in that the type of the transistor (11, 16, 22) of each stage is chosen such that the pulses corresponding to an increase in the incident radiation supplied to its base by the output of the preceding stage cause an increase of its collector current which means for the cascade mounted common emitter circuits that the preamplifier (10) is equipped alternately with complementary transistors.

5. Receiver according to claim 4, characterized in that the capacitances of the coupling capacitors (15, 23, 29) are respectively chosen so as to form with the sum of the respective resistive components of the output impedances of the preceding stage and the input of the stage concerned high-pass filters whose lower cut-off frequency is less than the frequency of the carrier or that equal to the reciprocal of twice the duration of the pulses when it is constant.

6. Receiver according to any one of the preceding claims, characterized in that the shaped stage (30) fed by the preamplifier (10) comprises a differential amplifier with two transistors (31, 32) coupled by their emitters and of type complementary to that of the transistor (22) in the last stage thereof, the first (31) of which has its base coupled to the collector of the latter (22) by means of a capacitor (29) and the second (32) of which is biased by means of a resistive voltage divider (36-37) whose common point is connected to its base in such a manner that it is conductive in the absence of pulse signal.

7. Receiver according to claim 6, characterized in that the base of the first transistor (31) of the shaping stage (30) is connected to that of the second (32) by means of a resistor (38) of high value, at the terminals of which the base residual current of the first transistor (31) causes a voltage drop sufficient for it to be biased beyond its cut-off point.

8. Receiver according to any one of claims 6 and 7, characterized in that the one (31) of the transistors (31, 32) of the differential amplifier which supplies the output stage (40) comprises in its collector circuit an integrating circuit or low-pass filter made up of a resistor (34) and a capacitor (35) which are connected in parallel and the upper cut-off frequency of which is chosen so as to appreciably reduce the noise affecting the pulse signal in order to supply to the output stage (40) signals with two logic levels corresponding substantially to the pulses modulating the carrier or the radiation.

9. Receiver according to any one of claims 6 to 8, characterized in that the output stage (40) comprises a bipolar junction transistor (41) mounted in common emitter and open collector.

10. Receiver according to claim 9, characterized in that the base of the transistor (41) in the output stage (40) is directly connected to the collector of one of the transistors (31, 32) with which the differential amplifier is provided.

11. Receiver according to claim 10, characterized in that the transistor (41) with which the output stage (40) is provided is of type complementary to those (31, 32) with which the differential amplifier is provided.

12. Receiver according to any one of claims 9 to 11, characterized in that the base of the transistor (41) of the output stage (40), of type NPN, forming an electronic interrupter, is connected to the collector of the first transistor (31) of the differential amplifier which supplies a low logic level in the absence of pulses and a high logic level when they are present.

13. Application of a remote control receiver according to any one of the preceding claims to a remote control system by electronic radiation, in particular infrared radiation, comprising a separate remote control transmitter in which coded pulses of constant amplitude possibly modulating a carrier serve to transmit a plurality of remote control signals by feeding at least one electroluminescent diode generating said radiation.

0 046 421